# EUROPEAN PATENT APPLICATION

(11) **EP 4 779 681 A1**
(43) Date of publication of application: **22.07.2026**
(21) Application number: 24892821.0
(22) Date of filing: 09.07.2024
(51) Int. Cl.: H01L 21/66

(54) **SEMICONDUCTOR PROCESSING DEVICE AND SEMICONDUCTOR PROCESSING METHOD THEREFOR**

(30) Priority: 20.11.2023 CN 202311556902
(71) Applicant: Huaying Research Co., Ltd, Wuxi, Jiangsu 214000 (CN)
(72) Inventor: WEN, Sophia Ziying, Wuxi, Jiangsu 214000 (CN); MA, Jie, Wuxi, Jiangsu 214000 (CN)
(74) Representative: Sun, Yiming
(86) International application number: PCT/CN2024/104417
(87) International publication number: WO 2025/107657

(57) **Abstract**

The present disclosure discloses a semiconductor processing system and a semiconductor processing method, the semiconductor processing device comprises a first chamber and a second chamber. The first chamber and/or the second chamber has a recessed groove. The recessed groove is capable of forming a sealed channel by the blocking of the surface of the wafer; a target fluid is driven into the sealed channel, and the fluid entering the sealed channel is capable of moving forward along the sealed channel and flowing out of the sealed channel. Within a period of time, the sealed channel contains multiple segments of the target fluid, and two adjacent segments of the target fluid are separated by a spacing fluid. In this way, without increasing the volume of the target fluid and with almost no increase in scanning time, the effective contact time of the target fluid with each point of the wafer can be increased, improving the efficiency of extracting contaminants from the wafer surface.

## Description

### TECHNICAL FIELD

The present disclosure relates to the field of semiconductor technology, and in particular to a semiconductor processing device and a semiconductor processing method.

### BACKGROUND

As semiconductor dimensions further decrease, impurities contained in the wafer silicon material itself have become a requirement for quality control monitoring. However, current wafer contamination detection techniques are limited to extracting and detecting contamination on the wafer surface or performing destructive testing on the entire wafer material.

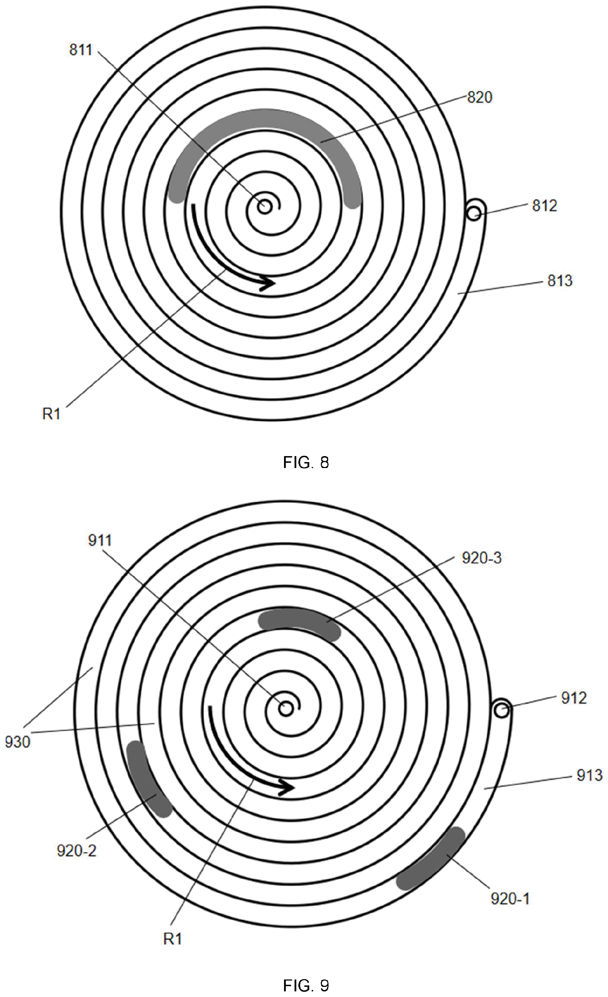

Chinese patent application 201510836143.0 discloses a method for detecting wafer contamination using a sealed channel within a micro chamber. As shown in FIG.8, the sealed channel 813 communicates with the exterior through a first through-hole 811 and a second through-hole 812. A certain volume of extraction solution 820 is driven into the sealed channel 813 through the first through-hole 811. The extraction solution 820 entering the sealed channel 813 is pushed by nitrogen to move forward along the guidance of the sealed channel (i.e., spiraling forward in direction R1), and the extraction solution 820 flowing over the surface of the wafer flows out through the second through-hole 812 and is extracted. That is, the extraction solution 820 is used to scan the surface of the wafer, so that a certain volume of extraction solution 820 can be used to extract and detect contaminant impurities on the wafer surface. However, in the conventional extraction method shown in FIG. 8, only one segment of extraction solution 820 can be loaded per scan. The volume of the extraction solution is typically 1 ml, and the nitrogen pushing speed is typically 20 ml/min. It can be calculated that the contact time of the extraction solution with each point on the wafer is 1 ml / (20 ml/min) = 0.05 min = 3 s. The contact time per point on the wafer has a significant impact on poorly soluble contaminants. Generally, the longer the contact time, the less contamination remains on the wafer and the higher the extraction efficiency. To improve extraction efficiency, feasible methods are to increase the volume of the extraction solution or decrease the nitrogen pushing speed. However, increasing the solution volume will raise the detection limit of the equipment, and decreasing the nitrogen pushing speed will increase the scan time, thereby affecting throughput.

It should be noted that the above description of the technical background is only for the convenience of clearly and completely explaining the technical solution of the present disclosure and for the convenience of understanding by the technical personnel in this field. It should not be considered that the above technical solutions are well known to those technical personnel in this field just because they are described in the background section of the present disclosure.

### SUMMARY

The present disclosure provides a semiconductor processing system and a semiconductor processing method, which can increase the effective contact time of a target fluid with each point of a wafer without increasing the volume of the target fluid and with almost no increase in scanning time, thereby improving the efficiency of extracting contaminants from the wafer surface.

To achieve the above objective, the present disclosure provides a semiconductor processing device, comprising: a first chamber, a second chamber movable relative to the first chamber between an open position and a closed position, wherein when the second chamber is at the closed position relative to the first chamber, a micro chamber is formed between the first chamber and the second chamber, and a semiconductor wafer can be accommodated in the micro chamber, and when the second chamber is at the open position relative to the first chamber, the semiconductor wafer can be transferred into or out of the micro chamber; the first chamber and/or the second chamber comprises a recessed groove formed by being recessed from an inner wall surface of the corresponding chamber, a first through-hole penetrating from the exterior through the corresponding chamber to communicate with a first position of the recessed groove, and a second through-hole penetrating from the exterior through the corresponding chamber to communicate with a second position of the recessed groove; wherein when the second chamber is at the closed position relative to the first chamber and the semiconductor wafer is accommodated between the first chamber and the second chamber, the surface of the semiconductor wafer abuts against the inner surface forming the recessed groove, and the recessed groove forms a sealed channel by the blocking of the surface of the semiconductor wafer, the sealed channel communicating with the exterior through the first through-hole and the second through-hole; a target fluid is driven into the sealed channel through the first through-hole, the target fluid entering the sealed channel is capable of moving forward along the sealed channel, at which time the target fluid is capable of contacting a portion of the surface of the wafer, and the target fluid flowing over the surface of the wafer flows out through the second through-hole and is extracted, wherein, within a period of time, the sealed channel contains multiple segments of the target fluid, and two adjacent segments of the target fluid are separated by a spacing fluid.

According to another aspect of the present disclosure, the present disclosure provides a semiconductor processing method based on the semiconductor processing system described above, comprising: dividing a target fluid into multiple segments, and separating two adjacent segments of the target fluid by a spacing fluid; introducing the multiple segments of the target fluid separated by the spacing fluid into one sealed channel through the first through-hole, so that within a period of time, the sealed channel contains multiple segments of the target fluid, and two adjacent segments of the target fluid are separated by the spacing fluid; by a driving fluid, the multiple segments of the target fluid separated by the spacing fluid in the sealed channel are driven to flow out of the sealed channel through the second through-hole; and combining the multiple segments of the target fluid flowing out of the sealed channel for detection.

Compared to existing techniques, in the present disclosure divides the target fluid into multiple segments and separates two adjacent segments of the target fluid by a spacing fluid, thereby obtaining multiple segments of the target fluid separated by the spacing fluid. The multiple segments of the target fluid separated by the spacing fluid are driven into the sealed channel. In this way, without increasing the volume of the target fluid and with almost no increase in scanning time, the effective contact time of the target fluid with each point of the wafer can be increased, improving the efficiency of extracting contaminants from the wafer surface.

Therefore, it should be understood that providing this summary is only for the purpose of summarizing some embodiments to offer a basic understanding of some aspects of the present disclosure. Thus, the above embodiments are merely examples and should not be construed as narrowing the scope or spirit of the present disclosure in any way. Through reading the following detailed description and the accompanying drawings, the features, appearance and advantages of each embodiment will be apparent, and the drawings illustrate the principles of some embodiments by way of example.

### BRIEF DESCRIPTION OF THE DRAWINGS

The present disclosure may be better understood by referring to the drawings as well as the detailed description below. In particular, same numerals are used to refer to same structural parts throughout the drawings, and wherein:
FIG. 1a illustrates a cross-section view of a schematic diagram of a semiconductor processing device of the present disclosure, according to one embodiment;
FIG. 1b illustrates an enlarge schematic diagram of a circle A shown in FIG. 1a;
FIG. 1c illustrates an enlarge schematic diagram of a circle B shown in FIG. 1a;
FIG. 2a illustrates a top view of a second chamber of the present disclosure, according to one embodiment;
FIG. 2b illustrates an enlarge schematic diagram of a circle C shown in FIG. 2a;
FIG. 2c illustrates an enlarge schematic diagram of a circle D shown in FIG. 2a;
FIG. 2d illustrates a cross-sectional schematic diagram along a section line A-A of FIG. 2a;
FIG. 2e illustrates an enlarge schematic diagram of a circle E shown in FIG. 2d;
FIG. 2f illustrates an enlarge schematic diagram of a circle F shown in FIG. 2a;
FIG. 3a illustrates a top view of a first chamber, according to one embodiment of the present disclosure;
FIG. 3b illustrates an enlarge schematic diagram of a circle G shown in FIG. 3a;
FIG. 3c illustrates an enlarge schematic diagram of a circle H shown in FIG. 3a;
FIG. 3d illustrates a cross-section view of the semiconductor wafer along a section line B-B of FIG. 3a;
FIG. 3e illustrates an enlarge schematic diagram of a circle I shown in FIG. 3d;
FIG. 3f illustrates an enlarge schematic diagram of a circle J shown in FIG. 3a;
FIG. 4a illustrates a cross-section view of a schematic diagram of a semiconductor processing device of the present disclosure, according to another embodiment;
FIG. 4b illustrates an enlarge schematic diagram of a circle K shown in FIG. 4a;
FIG. 5a illustrates a top view of a first chamber of the present disclosure, according to one embodiment;
FIG. 5b illustrates a cross-section view of the semiconductor wafer along a section line C-C of FIG. 5a;
FIG. 5c illustrates an enlarge schematic diagram of a circle L shown in FIG. 5a;
FIG. 6a illustrates a top view of a second chamber, according to another embodiment of the present disclosure;
FIG. 6b illustrates an enlarge schematic diagram of a circle M shown in FIG. 6a;
FIG. 7 is a flowchart of a semiconductor processing method according to one embodiment of the present disclosure.
FIG. 8 is a schematic diagram showing the structure for detecting wafer contamination using a sealed channel within a micro chamber in existing techniques;
FIG. 9 is a schematic diagram showing the structure for detecting wafer contamination using a sealed channel of the semiconductor processing device according to the present disclosure;
FIG. 10 is a flowchart of the semiconductor processing method according to another embodiment of the present disclosure.

### DETAILED DESCRIPTION OF THE PREFERRED EMBODIMENTS

Some embodiments of the present disclosure will be described more fully hereinafter with reference to the accompanying drawings, in which some, but not all embodiments are set forth. Indeed, various embodiments of the present disclosure may be embodied in many different forms and should not be construed as limited to the embodiments set forth herein; rather, these embodiments are provided so that the present disclosure will be thorough and complete, and will fully convey the scope of the present disclosure to the technical personnel in this field. For example, unless otherwise indicated, referring to something as a first, second, etc. should not be construed as implying a particular order. Also, something may be described as being above something else (unless otherwise indicated) but in fact may be below it, and vice versa; similarly, something described as being on the left may be on the right, and vice versa. The same reference numerals always refer to the same elements.

The details of the present disclosure can be more clearly understood with reference to the accompanying drawings and the description of the specific embodiments of the present disclosure. However, the specific embodiments of the present disclosure described herein are only for the purpose of explaining the present disclosure and should not be construed as limiting the present disclosure in any way. Under the teaching of the present disclosure, those skilled in the art can conceive of any possible modifications based on the present disclosure, which should be regarded as falling within the scope of the present disclosure. It should be noted that when an element is referred to as being "disposed on" another element, it can be directly on the other element or intervening elements may also be present. When an element is considered to be "connected" to another element, it can be directly connected to the other element or intervening elements may be present simultaneously. The terms "mounted," "connected," and "coupled" should be understood in a broad sense, for example, it may be a mechanical connection or an electrical connection, or it may be an internal communication between two elements, it may be a direct connection or an indirect connection through an intermediate medium. For those of ordinary skill in the art, the specific meanings of the above terms can be understood according to specific circumstances. The terms "vertical," "horizontal," "upper," "lower," "left," "right" and similar expressions used herein are for illustrative purposes only and do not represent the only embodiments.

Unless otherwise defined, all technical and scientific terms used herein have the same meaning as commonly understood by the technical personnel in this field to which this application belongs. The terms used in the specification of the present application herein are for the purpose of describing specific implementations only and are not intended to limit the present application. The term "and/or" as used herein includes any and all combinations of one or more of the associated listed items.

### Part 1

To better extract and detect contaminant impurities in a wafer, a semiconductor processing device is also proposed in present disclosure.

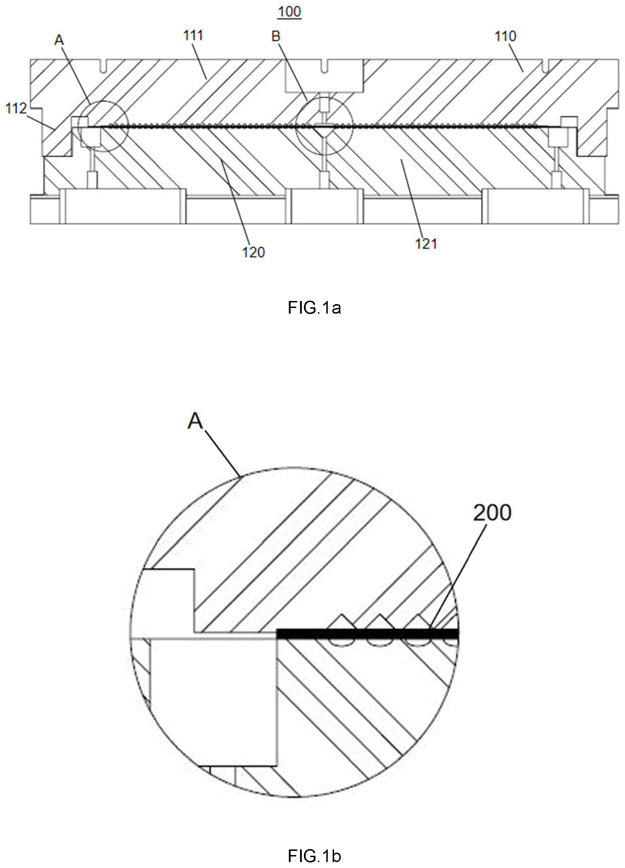

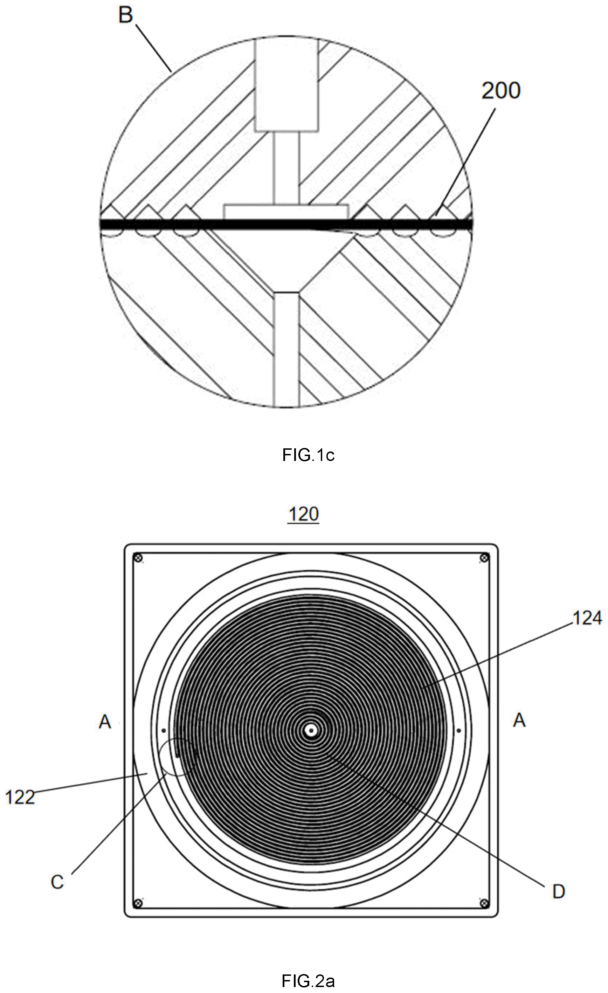

FIG. 1a illustrates a cross-section view of a schematic diagram of a semiconductor processing device 100 of the present disclosure, according to one embodiment; FIG. 1b illustrates an enlarge schematic diagram of a circle A shown in FIG. 1a; FIG. 1c illustrates an enlarge schematic diagram of a circle B shown in FIG. 1a; As shown in FIG. 1a, the semiconductor processing device 100 includes a first chamber 110 and a second chamber 120. In this embodiment, the first chamber 110 is the upper chamber, and the second chamber 120 is the lower chamber. In other embodiments, the lower chamber could also be defined as the first chamber, and the upper chamber as the second chamber.

The first chamber 110 comprises an upper chamber plate 111 and a first protruding edge 112 extended downward from the periphery of the upper chamber plate. The second chamber 120 comprises a lower chamber plate 121 and a first recessed groove 122 that dented downward at the periphery of the lower chamber plate 121.

The first chamber 110 is movable relative to the second chamber 120 between an open position and a closed position. When the first chamber 110 is at the open position relative to the second chamber 120, a semiconductor wafer to be processed can be placed on or taken out of an inner wall surface of the second chamber 120. When the first chamber 110 is at the closed position relative to the second chamber 120, the first protruding edge 112 cooperates with the first recessed groove 122 to form a sealed micro chamber between the upper and lower chamber plates, accommodating the semiconductor wafer for subsequent process.

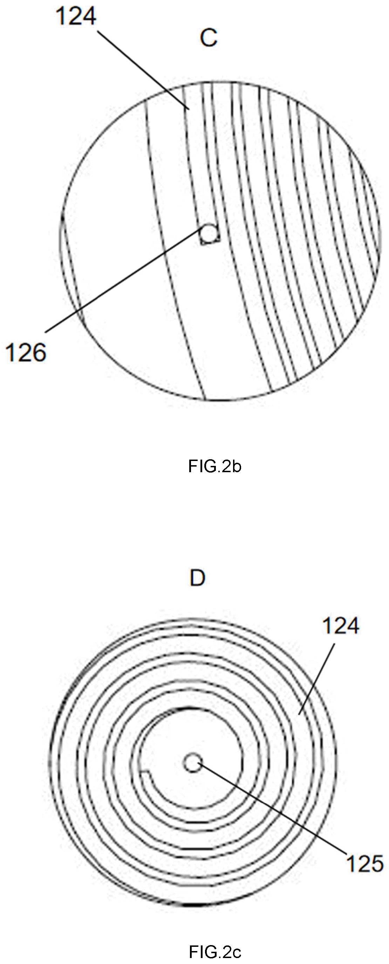

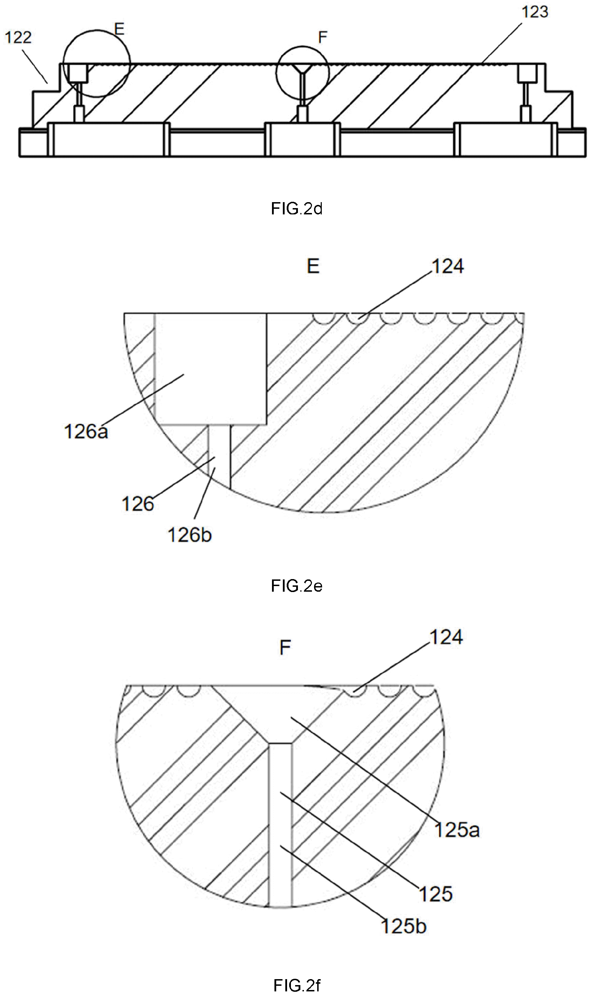

FIG. 2a illustrates a top view of a second chamber, according to one embodiment; FIG. 2b illustrates an enlarge schematic diagram of a circle C shown in FIG. 2a; FIG. 2c illustrates an enlarge schematic diagram of a circle D shown in FIG. 2a; FIG. 2d illustrates a cross-section view of the semiconductor wafer along a section line A-A of FIG. 2a; FIG. 2e illustrates an enlarge schematic diagram of a circle E shown in FIG. 2d; FIG. 2f illustrates an enlarge schematic diagram of a circle F shown in FIG. 2a.

As shown in FIGS. 2a-2f, the second chamber 120 comprises a recessed groove 124 formed by being recessed from the inner wall surface 123 of the second chamber 120 facing the micro chamber, a first through-hole 125 penetrating from the exterior through the second chamber to communicate with a first position of the recessed groove 124, and a second through-hole 126 penetrating from the exterior through the second chamber to communicate with a second position of the recessed groove 124. The cross-section of the recessed groove 124 may be U-shaped, V-shaped, or semicircular, or other shapes. The number of through-holes in the recessed groove 124 may be one or more.

As shown in FIGS. 1a, 1b, and 1c, when the first chamber 110 is at the closed position relative to the second chamber 120 and the semiconductor wafer 200 is accommodated in the micro chamber, one surface (lower surface) of the semiconductor wafer 200 abuts against the inner wall surface 123 forming the recessed groove 124. At this time, the recessed groove 124 forms a sealed channel by the blocking of the surface of the semiconductor wafer 200, and this sealed channel communicates with the exterior through the first through-hole 125 and the second through-hole 126. In application, a processing fluid can enter the sealed channel through the first through-hole 125, and the fluid entering the sealed channel is capable of moving forward guided by the sealed channel. At this time, the processing fluid then being able to contact a portion of the surface of the semiconductor wafer 200, and the fluid flowing over the surface of the semiconductor wafer 200 flowing out through the second through-hole 126 and be extracted. In this way, not only can the flow direction and flow rate of the processing fluid be precisely controlled, but also significantly reduce fluids consumption.

In one embodiment, as shown in FIGS. 2a, 2b, and 2c, the recessed groove 124 rings and forms a spiral shape. The first through-hole 125 is located at the central region (area circled as D) of the spiral recessed groove, and the second through-hole 126 is located at the peripheral region (area circled as C) of the spiral recessed groove124. The first through-hole 125 may serve as an inlet, while the second through-hole 126 serves as an outlet. In other embodiments, the first through-hole 125 may serve as an outlet, while the second through-hole 126 serves as an inlet. In other embodiments, the second through-hole is located at the central region of the spiral recessed groove, and the first through-hole is located at the peripheral region of the spiral recessed groove.

In one embodiment, as shown in FIGS. 2d, 2e, and 2f, the first through-hole 125 comprises a first buffer port 125a which directly connected to the recessed groove 124 and is deeper and wider than the recessed groove 124, and a first through-hole port 125b connected to the first buffer port 125a. The first buffer port 125a can prevent over-treating the central area of the semiconductor wafer from excessive initial flow velocity of the processing fluid. The second through-hole 126 comprises a second buffer port 126a which directly connected to the recessed groove 124 and is deeper and wider than the recessed groove 124, and a first through-hole port 126b connected to the first buffer port 126a. The second buffer port 126a can prevent the processing fluid overflow from the second through-hole 126 due to unable to be discharged in a timely manner. Preferably, the first buffer port 125a may be a tapered recess, while the second buffer port 126a may be a cylindrical recess.

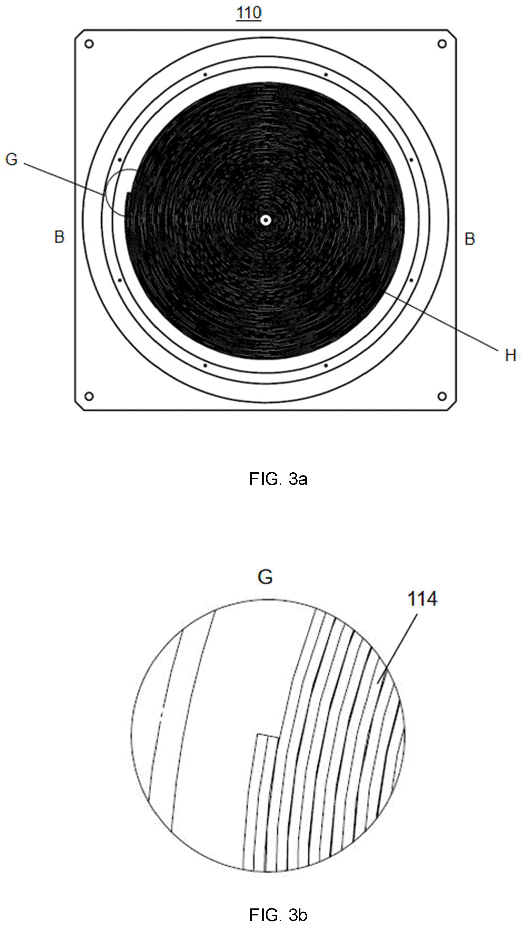

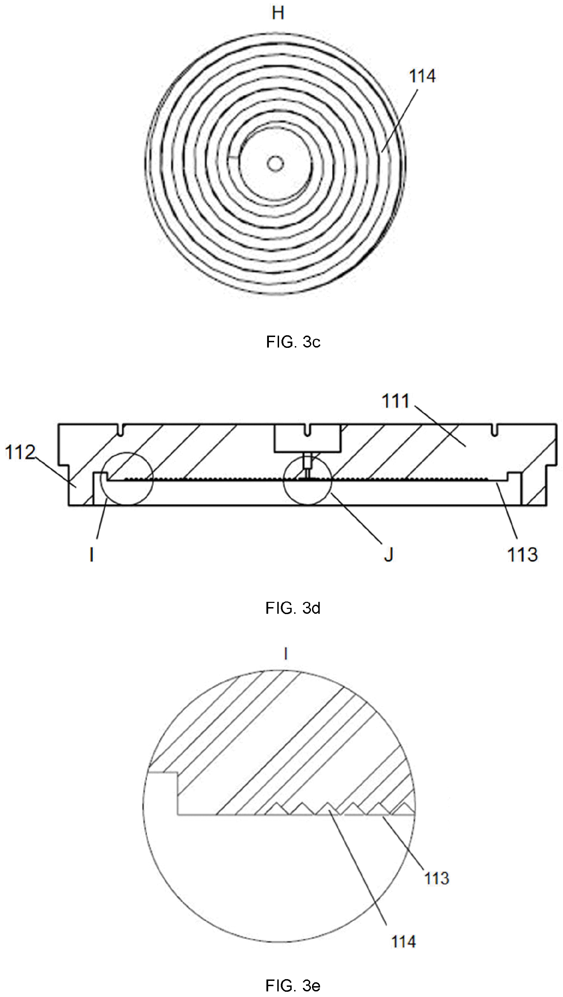

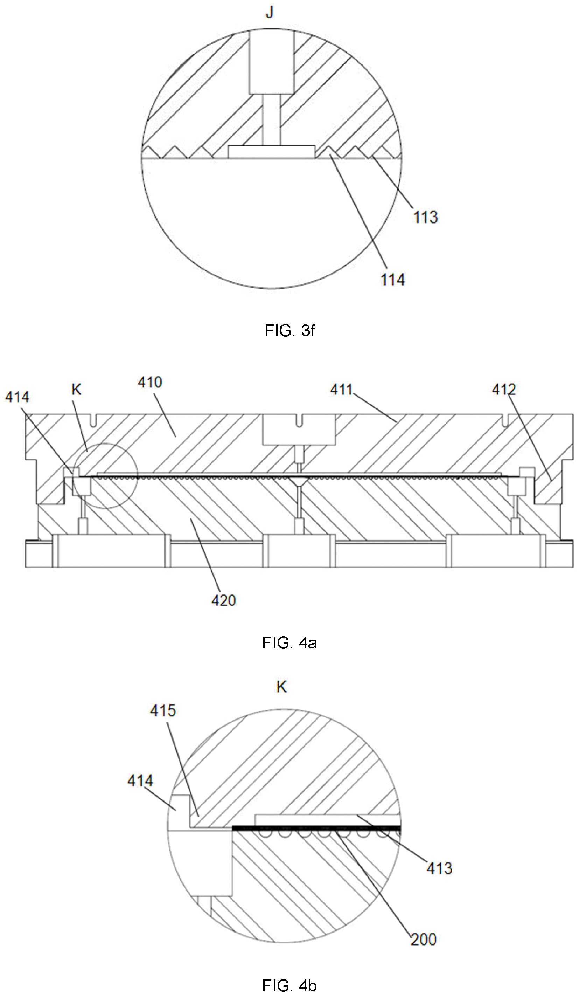

FIG. 3a illustrates a top view of a first chamber, according to one embodiment of the present disclosure; FIG. 3b illustrates an enlarge schematic diagram of a circle G shown in FIG. 3a; FIG. 3c illustrates an enlarge schematic diagram of a circle H shown in FIG. 3a; FIG. 3d illustrates a cross-section view of the semiconductor wafer along a section line B-B of FIG. 3a; FIG. 3e illustrates an enlarge schematic diagram of a circle I shown in FIG. 3d; FIG. 3f illustrates an enlarge schematic diagram of a circle J shown in FIG. 3a.

As shown in FIGS. 3a-3f, the first chamber 110 comprises an upper chamber plate 111 and a first protruding edge 112 extended downward from the periphery of the upper chamber plate 111. The first chamber 110 comprises a recessed groove 113 formed on an recessed inner wall surface 123 facing the micro chamber. The groove walls (portions between adjacent the recessed groove 114) of the recessed groove 114 which is formed on the inner wall surface 123 of the first chamber 110, align with (FIGS. 1b, 1c) the groove walls (portions between adjacent the recessed groove 124) of the recessed groove 124 which is formed on the inner wall surface 123 of the second chamber 120. In this way, when the first chamber 110 is at the closed position relative to the second chamber 120 and the semiconductor wafer 200 is accommodated in the micro chamber, the groove walls of the recessed groove 114 of the first chamber 110 may be abutted against corresponding positions of the semiconductor wafer 200, ensuring tighter contact with the groove walls of the recessed groove 124 of the second chamber 120. This enhances the sealing performance of the final formed sealed channel. Additionally, the groove walls (portions between adjacent the recessed groove 114) of the recessed groove 114 formed on an inner wall surface 123 of the upper chamber and the groove walls (portions between adjacent the recessed groove 124) of the recessed groove 124 formed on an inner wall surface 123 of the second chamber 120 may be arranged in an alternating pattern.

In another modified embodiment, the structures of the first chamber 110 and the second chamber may be interchangeable or identical. In this case, the upper surface of the semiconductor wafer 200 forms a sealed channel with the recessed groove of the first chamber 110. Processing fluid flowing through the sealed channel can process the upper surface or lower surface, or both surfaces at the same time of the semiconductor wafer 200 to be processed.

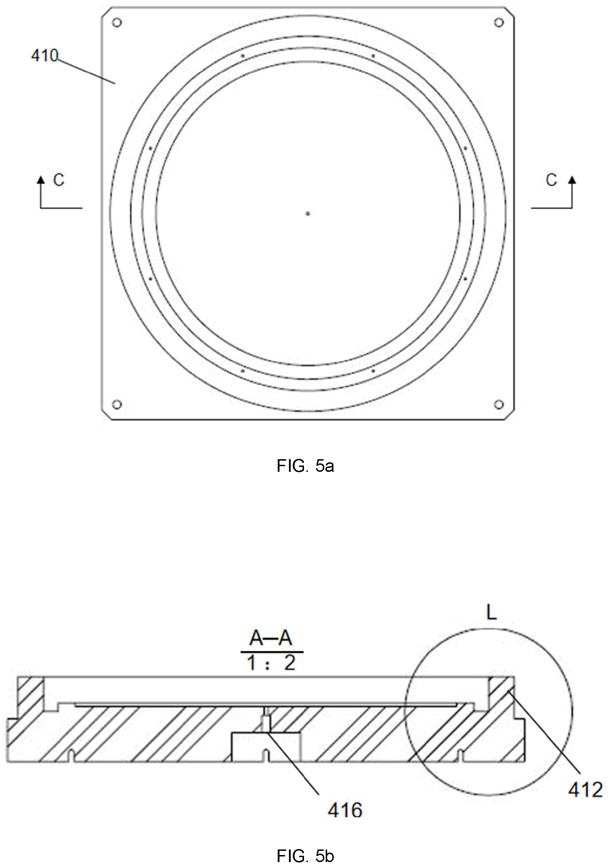

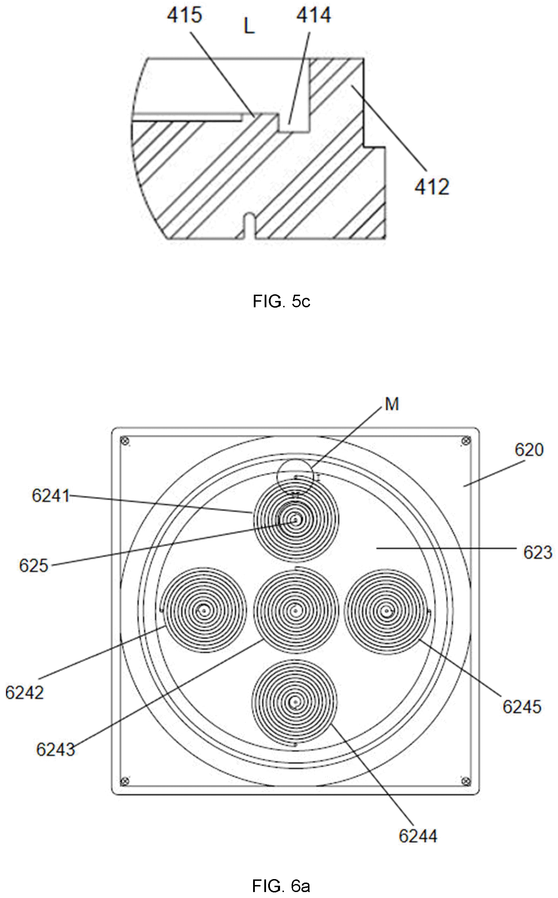

FIG. 4a illustrates a cross-section view of a schematic diagram of a semiconductor processing device of the present disclosure, according to another embodiment 200; FIG. 4b illustrates an enlarge schematic diagram of a circle K shown in FIG. 4a. The difference between the device 400 in FIG. 4a and the device in FIG. 1a is that the structure of the first chamber 410 in FIG. 4a differs from the structure of the first chamber 110 in FIG. 1a. FIG. 5a illustrates a top view of a first chamber 410 of the present disclosure, according to one embodiment; FIG. 5b illustrates a cross-section view of the semiconductor wafer along a section line C-C of FIG. 5a; FIG. 5c illustrates an enlarge schematic diagram of a circle L shown in FIG. 5a. As shown in FIGS. 5a-5c, the first chamber 410 comprises an upper chamber plate 411, a first protruding edge 412, a first inner wall surface 413 facing the micro chamber, a second recessed groove 414, a second protruding edge 415 between the first inner wall surface 413 and the second recessed groove 414, and a passage 416 at the center of the first inner wall surface 413. The second protruding edge 415 abuts against the semiconductor wafer 200 and the first inner wall surface 413 to form a sealed space, which connects with the exterior through the passage 416. Fluid entering the sealed space through the passage 416 generates pressure, pressing the semiconductor wafer 200 tightly against the groove walls of the recessed groove 124 of the second chamber 120, thereby improving the sealing performance of the final formed sealed channel.

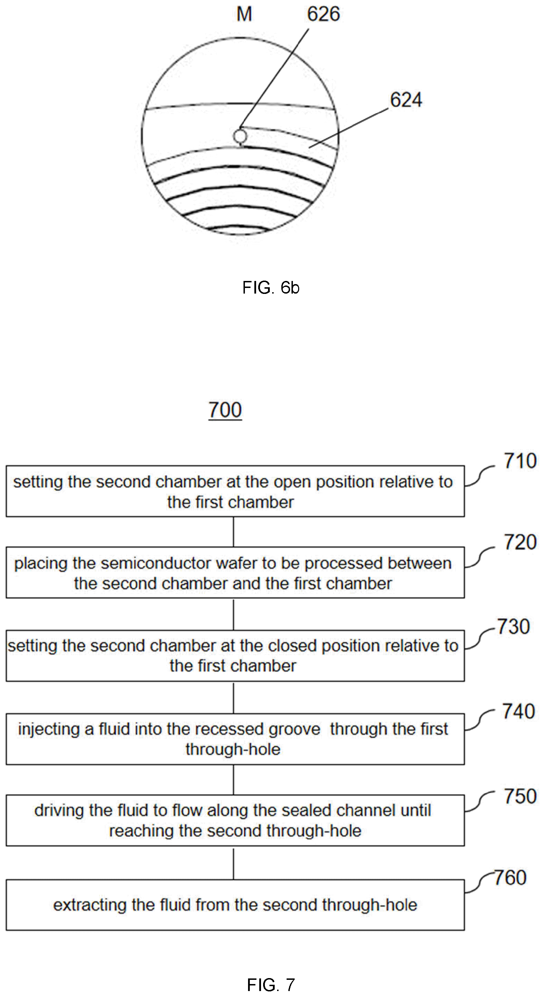

FIG. 6a illustrates a top view of a second chamber, according to another embodiment of the present disclosure; FIG. 6b illustrates an enlarge schematic diagram of a circle M shown in FIG. 6a. The recessed grooves 624 formed on the recessed inner wall surface 623 of the second chamber 620 facing the micro chamber are multiple. There are five recessed grooves in FIG. 6a, while in other embodiments, it may be other numbers. Each recessed groove 624 corresponds to a first through-hole 625 and a second through-hole 626. The different recessed grooves 624 are distributed in different regions of the inner wall surface 623, which allows for different operations to be performed to different regions, which are independent of each other.

The present disclosure also proposes a semiconductor processing method using the aforementioned device. As shown in FIG. 7, the semiconductor processing method 700 comprises the following steps:
Step 710: setting the second chamber 120 at the open position relative to the first chamber 110;
Step 720: placing the semiconductor wafer to be processed between the second chamber 120 and the first chamber 110;
Step 730: setting the second chamber 120 at the closed position relative to the first chamber 110;
Step 740: injecting a fluid into the recessed groove 124 through the first through-hole 125;
Step 750: driving the fluid to flow along the sealed channel until reaching the second through-hole 126;
Step 760: extracting the fluid from the second through-hole 126.

In one embodiment, elemental detection can be performed based on the extracted fluid, thus obtaining elements remaining on the surface of the semiconductor wafer and their concentrations.

In one embodiment, the fluid is a liquid, and the fluid is an extraction fluid. The extraction fluid is capable of extracting contaminant impurities from the contacted surface of the semiconductor wafer.

A driving fluid can be used to drive the fluid to flow in the sealed channel. The driving fluid is a non-reactive ultra-pure gas, such as nitrogen, helium, argon, ultra-pure water, acetone, carbon tetrachloride, etc.

In another embodiment, the first through-hole 125 can also serve as a fluid outlet, while the second through-hole 126 serves as a fluid inlet.

### Part 2

As shown in FIG. 8, it illustrates a traditional method for extracting contaminants from a wafer surface. The sealed channel 813, the first through-hole 811, and the second through-hole 812 in FIG. 8 can refer to the sealed channel, the first through-hole, and the second through-hole in the semiconductor processing device described above. As mentioned in the background, in the existing technology, only one segment of extraction solution 820 can be loaded each scan, which results in a low extraction efficiency.

Therefore, the present disclosure provides a semiconductor processing device and a semiconductor processing method that can solve the above problem.

FIG. 9 is a schematic diagram showing the structure for detecting wafer contamination using a sealed channel of the semiconductor processing device according to the present disclosure. As shown in FIG. 9, the semiconductor processing device comprises a first chamber and a second chamber. The first chamber and/or the second chamber comprises a recessed groove formed by being recessed from an inner wall surface of the corresponding chamber, a first through-hole 911 penetrating from the exterior through the corresponding chamber to communicate with a first position of the recessed groove, and a second through-hole 912 penetrating from the exterior through the corresponding chamber to communicate with a second position of the recessed groove; wherein when the second chamber is at the closed position relative to the first chamber and the semiconductor wafer is accommodated between the first chamber and the second chamber, and the recessed groove forms a sealed channel 913 by the blocking of the surface of the semiconductor wafer, the sealed channel 913 communicating with the exterior through the first through-hole 911 and the second through-hole 912. The structure of the semiconductor processing device in the present disclosure can refer to the semiconductor processing device mentioned above, and will not be repeated here.

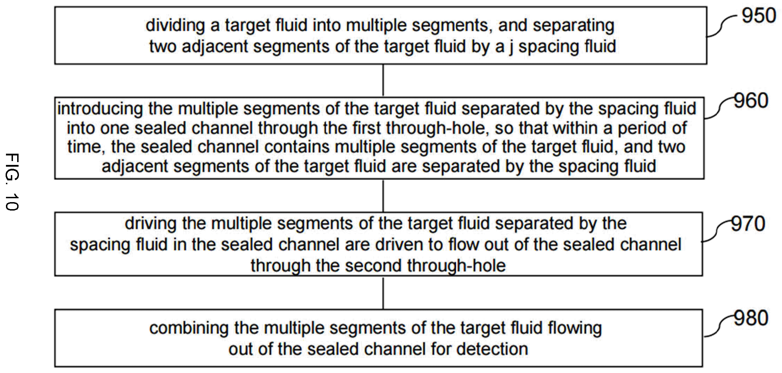

FIG. 10 is a flowchart of a semiconductor processing method based on the semiconductor processing device according to an embodiment of the present disclosure. Referring to FIG. 9 and FIG. 10, the semiconductor processing method comprises the following steps:
Step 950: dividing a target fluid into multiple segments, and separating two adjacent segments of the target fluid by a spacing fluid;

In one embodiment, the spacing fluid is a gas, and the target fluid is a liquid. For example, the spacing fluid is nitrogen. The target fluid is an extraction solution, and the extraction solution can be configured to extract contaminants on the surface of the wafer. The target fluid can also be referred to as a target extraction solution or extraction solution. For example, the extraction solution can react with contaminants (such as metal impurities or metal contaminants) and dissolve them into the extraction solution.

Step 960: introducing the multiple segments of the target fluid separated by the spacing fluid 930 into one sealed channel 913 through the first through-hole 911, so that within a period of time, the sealed channel contains multiple segments of the target fluid 920 (namely 920-1, 920-2, 920-3) , and two adjacent segments of the target fluid are separated by the spacing fluid;
As shown in FIG. 9, there are three segments of the target fluid, with a spacing fluid 930 between each two adjacent segments of the target fluid. In other embodiments, there may be 2, 4, or more segments of the target fluid. It should be particularly noted that the three segments of the target fluid 920 are in the same sealed channel, not respectively in multiple sealed channels.

Step 970: driving the multiple segments of the target fluid separated by the spacing fluid in the sealed channel by a driving fluid to flow out of the sealed channel through the second through-hole.

In one embodiment, the driving fluid is a gas. For example, the gas may also be nitrogen. The driving fluid and the spacing fluid may be the same gas.

Step 980: combining the multiple segments of the target fluid flowing out of the sealed channel for detection.

In one embodiment, a driving speed of the driving fluid is less than 40 ml/min, for example, it may be 20 ml/min, or 25 ml/min, etc. A total volume of the target fluid in the multiple segments of the target fluid is less than 3 ml (milliliter), for example, it may be 1 ml, 2 ml, etc.

Passing the multiple segments of the target fluid through the sealed channel once can be referred to as performing one scan using the multiple segments of the target fluid in the sealed channel. In one embodiment, the total volume of the target solution used for contaminant extraction using multiple segments of the target fluid can be the same as that using a single segment of the target fluid in existing techniques, so it does not affect the detection limit of the equipment. When the first segment of extraction solution 920-1 flows over a poorly soluble contaminant on the wafer surface, a trace amount of extraction solution may remain on the poorly soluble contaminant on the wafer surface, continuing to react with the poorly soluble contaminant (i.e., dissolving the contaminant) until the second segment of extraction solution 920-2 flows over that poorly soluble contaminant. That is, during the time between the first segment of extraction solution 920-1 and the second segment of extraction solution 920-2, the remaining trace amount of extraction solution will continue to dissolve and react with the poorly soluble contaminant, effectively significantly extending the contact time between the contaminant at the same point and the extraction solution. Therefore, the effective contact time of the extraction solution with each point on the wafer (here referring to each point on the wafer facing the sealed channel) is the duration of the multiple segments of extraction solution flowing over that point (e.g., 3 s) plus the total interval time of the spacing fluid flowing over that point between the multiple segments of extraction solution. The pushing speed of the driving gas (e.g., nitrogen) can remain unchanged, for example, at 20 ml/min, and the effective contact time of the extraction solution with each point on the wafer is significantly increased. It can be seen that by using a multi-segment scanning method, only adding a small amount of time intervals between multiple segments of extraction solution for introducing the spacing fluid can significantly increase the effective contact time of the extraction solution with each point on the wafer, improving the contaminant extraction efficiency in a single scan.

The present disclosure does not require changing the existing mechanical and electrical design, and can be implemented simply by modifying the existing recipe. The present disclosure can significantly increase the effective contact time of the extraction solution with each point on the wafer surface and improve the extraction efficiency of poorly soluble metal contaminants without increasing the volume of the extraction solution and with only a small increase in the total scanning time.

The above description is intended to be illustrative, not restrictive. Although the present disclosure has been described with reference to specific illustrative examples, it should be understood that the present disclosure is not limited to the described embodiments. The scope of the present disclosure should be determined with reference to the appended claims, along with the full scope of equivalents to which such claims are entitled.

The term 'one embodiment' or 'embodiment' referred to here refers to specific features, structures, or characteristics related to the embodiment that can be included in at least one implementation of the present disclosure. The phrase "in one embodiment" appearing in different places in this instruction does not necessarily refer to the same embodiment, nor does it necessarily mean a separate or alternative embodiment that is mutually exclusive with other embodiments. In the present disclosure, "multiple" and "several" refer to two or more. In the present disclosure, "and/or" represents "and" or "or". Additionally, the terms "first," "second," "third," "fourth," etc. used herein are intended as labels to distinguish between different elements, and may not necessarily have an ordinal meaning according to their numerical designation. Therefore, the terminology used herein is for the purpose of describing particular implementations only and is not intended to be limiting.

It should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

Although method operations are described in a particular order, it should be understood that other operations may be performed between the described operations. The described operational sequences may be adjusted so that they occur at slightly different times, or the described operations may be distributed in a system. The system allows for simultaneous processing of multiple unrelated programs.

Many modifications and other implementations of the present disclosure will come to mind of those skilled in the art having the benefit of the teachings presented in the foregoing descriptions and the associated drawings. Therefore, it is to be understood that the present disclosure is not to be limited to the specific embodiments disclosed and that modifications and other implementations are intended to be included within the scope of the appended claims. Moreover, although the foregoing description and the associated drawings describe example implementations of element and function combinations, alternative implementations of different combinations of elements and functions are also included within the scope of the appended claims. Different combinations of elements and/or functions than those explicitly described above are also set forth in the appended claims. Although specific terms are employed herein, they are used in a generic and descriptive sense only and not for purposes of limitation.

## Claims

1. A semiconductor processing device comprising: a first chamber, and a second chamber movable relative to the first chamber between an open position and a closed position,
wherein when the second chamber is at the closed position relative to the first chamber, a micro chamber is formed between the first chamber and the second chamber, and a semiconductor wafer can be accommodated in the micro chamber, and when the second chamber is at the open position relative to the first chamber, the semiconductor wafer can be transferred into or out of the micro chamber; the first chamber and/or the second chamber comprises a recessed groove formed by being recessed from an inner wall surface of the corresponding chamber, a first through-hole penetrating from an exterior through the corresponding chamber to communicate with a first position of the recessed groove, and a second through-hole penetrating from the exterior through the corresponding chamber to communicate with a second position of the recessed groove; wherein when the second chamber is at the closed position relative to the first chamber and the semiconductor wafer is accommodated between the first chamber and the second chamber, and the recessed groove forms a sealed channel by blocking of a surface of the semiconductor wafer, the sealed channel communicating with the exterior through the first through-hole and the second through-hole;
a target fluid is driven into the sealed channel through the first through-hole, the target fluid entering the sealed channel is capable of moving forward along the sealed channel, at which time the target fluid is capable of contacting a portion of the surface of the semiconductor wafer, and the target fluid flowing over the surface of the wafer flows out through the second through-hole and is extracted,
wherein, within a period of time, the sealed channel contains multiple segments of the target fluid, and two adjacent segments of the target fluid are separated by a spacing fluid.

2. The semiconductor processing device according to claim 1, wherein the spacing fluid is a gas, and the target fluid is a liquid, each segment of the target fluid is driven by a driving fluid, the driving fluid is a gas, and within a period of time, the multiple segments of the target fluid are in the same sealed channel.

3. The semiconductor processing device according to claim 2, wherein the target fluid in each segment of the target fluid is the same, and the target fluid is configured to extract contaminants on the surface of the wafer.

4. The semiconductor processing device according to claim 2, wherein the driving fluid is nitrogen, and the spacing fluid is nitrogen.

5. The semiconductor processing device according to claim 2, wherein a driving speed of the driving fluid is less than 40 ml/min, and a total volume of the target fluid in the multiple segments of the target fluid is less than 3 ml.

6. The semiconductor processing device according to claim 1, wherein each recessed groove forms a spiral shape, wherein one of the first through-hole and the second through-hole is located in a central region of the spiral-shaped recessed groove, and the other of the first through-hole and the second through-hole is located in a peripheral region of the spiral-shaped recessed groove.

7. A semiconductor processing method for a semiconductor processing device, the semiconductor processing device comprising: a first chamber, a second chamber movable relative to the first chamber between an open position and a closed position; wherein when the second chamber is at the closed position relative to the first chamber, a micro chamber is formed between the first chamber and the second chamber, and a semiconductor wafer can be accommodated in the micro chamber, and when the second chamber is at the open position relative to the first chamber, the semiconductor wafer can be transferred into or out of the micro chamber; the first chamber and/or the second chamber comprises a recessed groove formed by being recessed from an inner wall surface of the corresponding chamber, a first through-hole penetrating from an exterior through the corresponding chamber to communicate with a first position of the recessed groove, and a second through-hole penetrating from the exterior through the corresponding chamber to communicate with a second position of the recessed groove; wherein when the second chamber is at the closed position relative to the first chamber and the semiconductor wafer is accommodated between the first chamber and the second chamber, and the recessed groove forms a sealed channel by blocking of a surface of the semiconductor wafer, the sealed channel communicating with the exterior through the first through-hole and the second through-hole; comprising:
dividing a target fluid into multiple segments, and separating two adjacent segments of the target fluid by a spacing fluid;
introducing the multiple segments of the target fluid separated by the spacing fluid into one sealed channel through the first through-hole, so that within a period of time, the sealed channel contains multiple segments of the target fluid, and two adjacent segments of the target fluid are separated by the spacing fluid;
driving the multiple segments of the target fluid separated by the spacing fluid in the sealed channel by a driving fluid to flow out of the sealed channel through the second through-hole; and
combining the multiple segments of the target fluid flowing out of the sealed channel for detection.

8. The semiconductor processing method according to claim 7, wherein the spacing fluid is a gas, and the target fluid is a liquid, the driving fluid is a gas, within a period of time, the multiple segments of the target fluid are in the same sealed channel, and the target fluid is configured to extract contaminants on the surface of the wafer.

9. The semiconductor processing method according to claim 8, wherein the driving fluid is nitrogen, and the spacing fluid is nitrogen.

10. The semiconductor processing method according to claim 8, wherein a driving speed of the driving fluid is less than 40 ml/min, and a total volume of the target fluid in the multiple segments of the target fluid is less than 3 ml.
